Europäisches Patentamt

European Patent Office

Office européen des brevets

(11) Publication number: **0 228 901**
**A2**

## EUROPEAN PATENT APPLICATION

(21) Application number: 86310090.5

(22) Date of filing: 23.12.86

(51) Int. Cl.⁴: **H01J 37/20**

(30) Priority: 24.12.85 GB 8531723

(43) Date of publication of application:
**15.07.87 Bulletin 87/29**

(84) Designated Contracting States:
**CH DE FR GB LI NL**

(71) Applicant: VG INSTRUMENTS GROUP LIMITED
29 Brighton Road
Crawley West Sussex RH10 6AE(GB)

(72) Inventor: Stonestreet, Paul Richard
83 Farm Close
East Grinstead West Sussex(GB)
Inventor: Moffatt, Stephen
73 Weymede
Byfleet Surrey KT14 7DH(GB)
Inventor: Colling, John Anthony
Brambles
Buxted West Sussex(GB)

(74) Representative: Cockbain, Julian Roderick
Michaelson et al
Frank B. Dehn & Co. European Patent
Attorneys Imperial House 15-19, Kingsway
London WC2B 6UZ(GB)

(54) Wafer transfer apparatus.

(57) The invention provides wafer transferring apparatus for wafer processing apparatus, for example an ion implanter, plasma etcher, or sputter coater, in which wafers are automatically loaded into processing stations (23, 24, 25) in the process chamber - (35) of the apparatus from storage cassettes (1, 2, 3) located in a vacuum lock (38). Wafers are lifted in batches by a pick-up means (5) from the cassette and transferred into a cradle (9) which holds more than one wafer. The cradle is then moved to load into a processing station each wafer of the batch previously loaded into it. Consequently the number of cycles of the transferring apparatus is fewer than the number of wafers to be loaded, and particulate contamination of the processing chamber (35) is reduced.

FIG.1.

## WAFER TRANSFER APPARATUS

This invention relates to apparatus for the manufacture of electronic semiconductor devices and in particular to apparatus for automatically transferring semiconductor wafers between a processing station in an evacuated chamber and a storage cassette located outside the chamber.

Electronic semiconductor devices such as integrated circuits are manufactured in large quantities on silicon wafers up to 200mm in diameter, each wafer comprising up to 1000 individual microcircuits which undergo processing simultaneously. Many of the processes used, such as molecular team epitaxy, ion implantation, ion or electron beam lithography, plasma etching, sputter coating, etc, involve treatment of the wafer in an evacuated chamber, so that the need arises to transfer wafers between the standard cassettes in which they are stored and a processing station in the chamber. The wafers are very fragile and are easily damaged due to their thinness (usually less than 1.0mm) and their highly polished surfaces, and consequently the procedures used for their handling during the manufacturing processes are very important if large numbers of reject microcircuits are to be avoided. It is especially important to minimize the contamination of the wafer surfaces by particles, because the presence of even a single very small particle can result in a faulty microcircuit at the location of the particle. Consequently, great care has to be taken in the design of a wafer loading apparatus to ensure that it does not cause damage to the wafers and that its generation of particulate contamination is minimized. A major source of particulate contamination is the wear and abrasion of moving parts in the loading apparatus, so that in an ideal apparatus, the number of moving parts is minimized.

Various types of apparatus for handling and loading the wafers are described in the literature, and a variety of systems are used in commercial wafer processing equipment, especially ion implanters. Most modern systems will accept the standard cassettes used by the industry and have means for extracting the wafers from the cassette, loading them into a processing station inside the evacuated chamber, and returning the processed wafer to the cassette. The wafers are usually transferred into the evacuated chamber through a vacuum lock, often known as a load lock, to avoid the need to admit air into the evacuated chamber when wafers are being admitted or removed. Thus the mechanical wafer handling apparatus has to operate in co-operation with the load lock and the fabrication process itself, and a computer is often used to control the loading and unloading apparatus. Some typical prior art wafer loading systems are described by P.H. Rose (Nucl. Instr, Methods in Phys. Res., 1985, vol. B6, PI-8), A. Armstrong, V. Benveniste, M. Farley and G. Ryding (Ion Implantation, Equipment and Techniques, Springer Ser. in Electrophys., vol. 10, Ed: H. Ryssel and G. Glawisching, pp. 155-160), J. Pollock, N. Turner, R. Milgate, R. Resnck, and R. Hertel (Nucl. Inst. Methods in Phys. Res., 1985, vol. B6, pp 202-209), R. Liebert, B. Pederson, C. Ehrlich and W. Callaghan - (Nucl. Instr. Methods in Phys. Res. 1985, vol. B6, p16-26), O. Woodward, P. Lindsey, J. Cecil and R. Pipe (Nucl. Instr. Methods in Phys. Res, 1985, vol. B6, pp 146-153), K. Matsuda, T. Kawai, M. Naitoh, and M. Aoki (Nucl. Instr. Methods Phys. Res. 1985, B6 pp 35-38) and in US Patents 4,261,762, 4,228,358 and 4,311,427. Although these systems differ greatly in their detailed design, which is obviously adapted to suit the design of the processing equipment with which they are associated, they are all arranged to transfer and load only one wafer at a time. The loading apparatus must therefore undergo a complete cycle each time a wafer is loaded and unloaded, which represents the maximum possible number of operations to load a given number of wafers. Consequently the generation of small particles is also maximized. Another disadvantage of the prior art mechanisms is the length of time needed to load and unload the wafers individually, which can represent a large proportion of the operational time of the processing equipment, thereby tending to make the process uneconomic. This problem is particularly acute with large high current, high energy ion implanters, where the cost of the equipment is so high that it is necessary to process large numbers of wafers simultaneously to ensure economic operation. If the loading time of a large number of wafers is a significant proportion of the implantation time, the viability of the process is jeopardized. Many of the prior art loading systems are unsuited to a machine of this type.

A further problem encountered, particularly with the high power ion implanters, is the need to ensure efficient heat transfer from a wafer loaded in a processing station to a temperature controlled heat sink in order that the temperature of the wafer may be controlled during processing. This is conventionally achieved by ensuring good contact between the wafer and a cooled support which may also involve gas or liquid cooling and necessitate a vacuum tight seal between the wafer and the support. Consequently, complicated clip or clamp means are necessary to hold the wafer in position and the presence of these further complicates the loading apparatus. Recently, however, there have been developed very high power ion implanters in which the wafer processing temperature is typically several hundred °C, and it has been possible to utilize radiation cooling of the wafers in place of conduction cooling. Consequently, the wafer counting means in each processing station can be simplified because it is no longer necessary to ensure good thermal contact between the wafer and its support, and advantage of this can be taken to simplify the loading apparatus.

It is an object of the present invention, therefore, to provide apparatus for transferring wafers between a cassette, preferably a standard cassette, and a processing station inside an evacuated chamber which transfers wafers by means of a number of operational cycles smaller than the number of wafers to be transferred, thereby reducing the generation of particulate contamination.

Therefore in one aspect, the invention provides apparatus for transferring wafers from at least one storage cassette to a plurality of processing stations in an evacuated chamber wherein each said station is arranged to receive a single wafer and to retain it in position during processing thereof, said apparatus comprising:-

(a) a wafer pick-up means capable of simultaneously removing a first plurality of wafers simultaneously from said cassette;

(b) a wafer transporting cradle arranged to receive said plurality of wafers from said pick-up means;

(c) drive means arranged to move said cradle to each of a series of wafer transfer locations;

(d) wafer locating means operable when said cradle is at each of said wafer transferring locations to transfer one of said plurality of wafers to one of said processing stations.

In use, the wafer transfer apparatus of the invention will be located in a wafer processing apparatus, for example an ion implantation device.

Thus, according to a further aspect, the invention provides a wafer processing apparatus, for example an ion implanter, plasma etcher or sputter coater, comprising:-

(a) a vacuum lock capable of receiving at least one wafer storage cassette;

(b) a processing chamber for wafer processing, said chamber being provided with a plurality of wafer processing stations each capable of receiving a single wafer , and a vacuum isolating valve communicating with said vacuum lock;

(c) means for separately evacuating said chamber and said lock; and

(d) wafer transferring apparatus substantially as described above and arranged to transfer wafers from said cassette through said valve to said processing stations.

The wafer pick-up means conveniently is adapted for location beneath a cassette in the vacuum lock and is provided with drive means capable of moving it and the wafers picked up by it through a vacuum isolating valve into the evacuated processsing chamber to a position at which the wafers may be deposited in the wafer transporting cradle.

The wafer processing apparatus of the invention preferably includes at least one wafer carrying member disposed in the processing chamber, said carrying member comprising a plurality of processing stations and being provided, at each said processing station, with at least one stop member and at least two elongated wafer support members, each said support member being provided with a slot arranged to receive the lower portion of a wafer disposed therein substantially parallel to the plane of said carrying member, and each said stop member being arranged for contact with the upper portion of a wafer disposed in said support members whereby to prevent out-of-plane motion thereof towards said carrying member.

An important application of the wafer transfer apparatus of the invention is the loading of wafers into an ion implanter, plasma etcher or sputter coater,which is capable of processing a large number of wafers simultaneously. In apparatus of this kind, the wafers are supported on the inside of a large rotating drum. The wafer carrying member, typically supporting 3 wafers one above the other, may then comprise a flat rectangular plate fitted on the inside cylindrical surface of the drum. A plurality of such plates are fitted to complete the inner surface. A batch of 3 wafers is loaded by one cycle of the drive means on the first of the plates. The drum is then advanced to bring the next plate into the loading position and the process repeated with another batch of 3 wafers. In this way the process of loading the wafers is speeded up in comparison with the prior art apparatus in which each wafer is loaded individually.

It will be appreciated that when the wafers are supported on the inside of a rotating drum during processing, centrifugal force will maintain them in contact with the stop members and in the desired position for processing. No additional clip means are required to locate the wafers, especially when wafer temperature control is achieved by radiation cooling or heating of the wafers and not by conduction or convection cooling as in prior art implanters. In order to optimize the radiation cooling, a hole, slightly smaller in diameter than the wafer, may be provided in the wafer carrying member at each processing station, ensuring good radiative heat transfer from the rear of the wafer through the hole to a temperature controlled heat sink outside the rotating drum. The stop members and support members are preferably circular in cross section and are disposed around the circumference of the hole at each processing station. Preferably, two such stop members and two such support members are provided at each processing station. In such an ion implanter, the wafer carrying member, stop members and support members are preferably fabricated from quartz (for the reasons described in our British patent application No. 8523441, filed 23 Sept.1985 and in the corresponding European Patent Application No.86307273.2, a copy of which is on the file of the present application). However, it is also within the scope of the invention to provide conventional style wafer mountings and conduction or convection wafer cooling means, if required.

Preferably the storage cassette is situated in a vacuum lock connected to the evacuated processing chamber by a vacuum isolating valve and provided with a vacuum tight entrance door.

In a preferred embodiment of the apparatus of the invention the apparatus is provided with a conveyor means for said cassette(s), said conveyor means being operable to align a first plurality of wafers in said cassette over said pick-up means, and being further operable, subsequent to the transfer of a said plurality of wafers to said cradle, to align a second plurality of wafers in said cassette over said pick-up means, and so on until all said wafers have been loaded into said processing stations.

The conveyor means is conveniently mounted from the entrance door so that it is withdrawn from the lock when the door is removed, facilitating loading the cassettes. When the door is replaced, the conveyor means extends into the lock to enable the cassettes to be indexed over the wafer pick-up means. The lock should preferably be large enough to take several cassettes simultaneously. In operation, after the entrance door is replaced the lock chamber is evacuated. The isolating valve to the processing chamber is then opened, and the first cassette indexed over the wafer pick-up means, which is then used to lift the first batch of wafers through the isolating valve and deposit them in the wafer transporting cradle. The wafer pick-up means is then retracted below the cassettes, which are advanced by the conveyor means to index the second batch of wafers over the wafer pick-up means. Meanwhile the drive means loads the first batch of wafers into the processing stations, and returns the cradle to its starting position. The process is repeated until all the wafers have been loaded into the processing stations, after which the isolating valve is closed and the processing is commenced. After completion of processing, the valve is opened and the wafers returned to their original cassettes by reversing the steps described.

In practice the operation of the conveyor means, isolating valve and wafer pick-up means conveniently is automated and controlled by a digital computer.

Preferably also the conveyor means for the cassettes is inclined upwardly into the vacuum lock (typically at 3° to the horizontal) so that the wafers rest against one side of their locating grooves in the cassettes whilst they are being moved. This minimizes relative movement of the wafers and the cassettes which may otherwise result in physical damage to the wafers. Any suitable conveyor means may be employed, but a particularly suitable type comprises a sliding carriage on which the cassettes are placed which is driven by linear motion motor enclosed within a tube sealed from the evacuated lock chamber. A suitable mechanism is described later.

The wafer pick-up means may conveniently comprise a shoe capable of passing between the sides of the cassette and containing a plurality of grooves each adapted to receive the edge of one of said wafers and to support it in a substantially vertical orientation. The grooves are spaced apart by a distance equal to the spacing of the wafers in the cassette, so that the wafer pick-up means may lift the first plurality of wafers simultaneously as it is driven upwards through the cassette.

The wafer transporting cradle may conveniently comprise second and third shoes spaced apart to allow the shoe of the wafer pick-up means to pass between them, said second and third shoes being adapted to support a plurality of wafers in substantially vertical orientations at points just below their horizontal diameter, each of said second and third shoes further comprising a plurality of grooves each adapted to receive the edge of one of said wafers. The spacing of the grooves is made equal to the spacing of the wafers in the cassettes, and the shoes are preferably adapted to carry the same number of wafers as the wafer pick-up means.

In operation, the pick-up means lifts the first (or a subsequent) plurality of wafers from a cassette by a substantially vertical upward motion, until they are completely clear of the cassette. The pick-up means is then displaced substantially horizontally, and then lowered so that the shoe of the wafer pick-up means passes between the shoes of the cradle in such a way that the grooves in all the shoes are substantially in alignment, thereby transferring the wafers from the pick-up means to the cradle. The horizontal displacement of the pick-up means is conveniently obtained by slightly tilting the actuating rod which lifts the pick-up means so that the shoe is displaced in a substantially horizontal plane.

The cradle is attached to a drive means, located within the evacuated processing chamber, which is used to transfer the wafers to the processing stations. A variety of robot drive devices can be used, dependent on the relative positions of the loading point for the cradle in the processing chamber and the processing stations.

In a preferred embodiment of the invention, at least some of processing stations to be loaded are arranged to be in substantially vertical alignment with the wafers in the storage cassette which are being lifted by the pick-up means. The drive means may then conveniently comprise a cradle connecting arm linking the cradle to a linear motion guiding means adapted to confine the motion of the cradle to a single substantially vertical axis, and a crank member having a proximal end about which it is capable of pivoting and a distal end on which the guiding means is mounted, said crank member being adapted to move the guiding means clear of the processing stations to allow the cradle to be elevated on the guiding means to a point above the uppermost processing station, and subsequently to return the guiding means to its original position to permit the cradle to be lowered through each of said transfer locations in turn. Thus in order to raise the wafer support cradle to a position above the uppermost processing station, the crank member is first turned to move the guiding means and cradle clear of the processing stations, permitting the cradle to be elevated along the guiding means. The crank member is then turned back to its original position in which the wafers in the cradle are situated in the planes they will occupy in the processing stations, and the loading is completed by lowering the cradle past the stations.

Preferably, at least some of the processing stations are disposed one above another in such a way that a wafer located in one of them is spaced farther from the carrying member than the wafer in the station above it. This may be achieved for example by having the wafer contact face of the stop members and the wafer receiving grooves in the support members successively further away from the body of the wafer carrying member for successively lower processing stations.

The drive means may then be arranged to position the cradle above the uppermost processing station and to subsequently lower it through each of the wafer transferring locations in turn. Each of these transferring locations is preferably in horizontal alignment with the processing station into which the wafer in the transferring location is about to be loaded.

The guiding means conveniently comprises a rod member and a tube member, both substantially vertically disposed, mounted at the distal end of the crank member. The cradle connecting arm is slidably mounted on the rod and tube members so that its motion is confined to an axis parallel to both, and rotation is prevented. Preferably the tube member is non-magnetic and comprises a lead screw along its axis. A nut means in threaded engagement with the lead screw is also provided within the tube member, and means are also provided to prevent the nut rotating.

A first magnet means, also within the tube member, is attached to the nut means. Second magnet means are provided exterior to the tube member and attached to a slide member which is free to slide on the exterior of the tube member. The cradle connecting arm is attached to the slide member. The first and second magnet means act in magnetic co-operation with each other so that the slide and arm are caused to follow the motion of the nut means as it is driven up and down the tube by the leadscrew. Full details of a drive mechanism of this type are given in UK patent 1,317,105.

Rotary motion is transmitted to the lead screw by a toothed belt drive from a shaft concentric with the pivot at the proximal end of the crank member. Preferably the crank member is hollow, completely enclosing the toothed belt drive, and forming a sealed enclosure connected with the inside of the tube member. A conventional ferrofluidic seal may be used to seal the crank pivot where it passes through the wall of the processing chamber, so that the inside of the crank member and tube member, containing the moving parts of the robot drive means, remains at atmospheric pressure, and any wear particles formed are excluded from the processing chamber. Conventional servo drive motors, located outside the vacuum systems, may be used to provide the motion of the crank and guiding means.

Similar magnetically coupled linear motion drives may also be used to provide the vertical motion required by the wafer pick-up means, and the horizontal motion required by the conveyor means. The limited tilting motion of the pick-up means required to locate the wafers above the transporting cradle is conveniently provided by tilting the drive motor and pick-up means with an electromagnetic actuator.

It will be appreciated that other forms of linear motion actuators can be utilized without departing from the spirit of the invention.

In a further preferred embodiment, the locating means comprises at least two wheels disposed one on each side of the cradle, ie, one on each of the second and third shoes. The wheels are spaced apart so that they will pass either side of a wafer located in one of the processing stations. They are further disposed so that when the cradle is located at the uppermost processing station with the wheels in contact with the carrying member, each of the wafers in the cradle is substantially in vertical alignment with the slots in the support members associated with the processing station into which it is about to be loaded. The wafers are then loaded simply by causing the cradle to descend through each transferring location in turn with the wheels in contact with the carrying member, whereby each wafer is located in turn in the grooves of the support members of the appropriate processing station.

In this way the need for very accurate positioning of the cradle by the robot means is reduced, and any slight misalignment of the axis of the guiding means and the plane of wafer carrying member is automatically compensated. This is especially important in the case of a large ion implanter which may carry as many as 28 individual wafer carrying members on the inner suface of a 1.5m diameter rotating drum, whilst it is necessary that the wafers are positioned within 0.5mm of the desired plane for location in the slots of the lower support members to take place without the risk of damage to the wafers.

Control of the entire wafer transfer apparatus is preferably achieved by means of a suitably programmed digital computer using conventional techniques. Position sensing devices, for example limit switches or photoelectric sensors, may be provided to give control signals indicative of the exact position of the various components and improve the precision of the operation.

Preferred embodiments of the invention will now be described by way of example and in greater detail with reference to the following drawings, in which:-

figure 1 is a perspective drawing showing the principal components of a wafer transfer apparatus according to the invention;

figure 2 is a drawing of the principal components of a wafer processing apparatus of the invention incorporating the apparatus of figure 1;

figure 3 is a sectional view of a linear motion guiding means suitable for use in the invention;

figures 4A and 4B are two views of a wafer carrier suitable for use in the apparatus of figure 2; and

figure 5 is a cross sectional view of part of a robot means suitable for use in the invention.

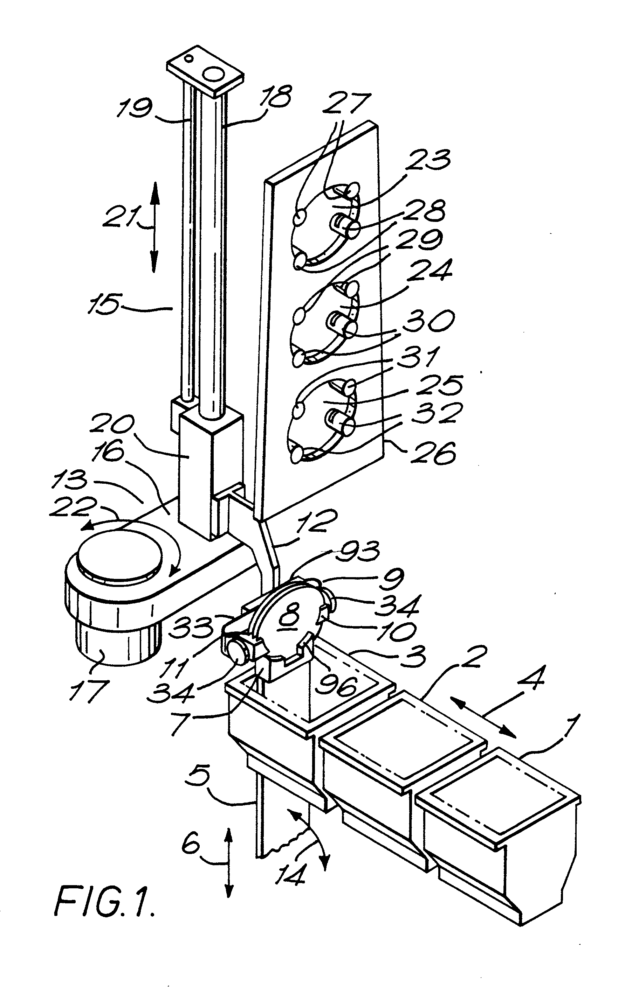

Referring first to figure 1, which illustrates the principal components of a preferred embodiment of the wafer transfer apparatus, storage cassettes I, 2, and 3 are moved along the direction of arrow 4 by a conveyor means (not shown), until the first batch of wafers (typically three) is positioned over the wafer pick-up means 5. As explained below, the cassettes and conveyor means are located in a vacuum lock. Wafer pick-up means 5 is then elevated along the direction of arrow 6 so that the first pick-up shoe 7 lifts the first batch of three wafers 8 from the cassette and carries them into the processing chamber.

A wafer transporting cradle generally indicated by 9 and comprising second and third shoes 10 and 11 connected by means of 'U' shaped leaf springs 33 to bracket 93 attached to cradle supporting arm 12 on robot drive means 13, is positioned in the processing chamber slightly below the position of the fully elevated pick-up shoe 7 and displaced from it along an axis perpendicular to the planes of wafers 8. Wafer pick-up means 5 is then tilted slightly as indicated by arrow 14 so that wafers 8 are aligned with the grooves in shoes 10 and 11, and the pick-up means 5 is then lowered, leaving wafers 8 supported in shoes 10 and 11. Figure 1 shows the wafers being located in shoes 10 and 11 as pick-up shoe 7 on pick-up means 5 is descending. Pick-up means 5 is then further retracted below the base of cassette 3 in preparation for the lifting of the next batch of wafers.

Preferably each of the shoes 7, 10 and 11 contains a plurality of grooves 96, each groove adapted to receive the edge of one of the wafers and support it in a substantially vertical orientation. Shoe 7 is adapted to support a batch of wafers on its own, as shown in figure 1, whilst shoes 10 and 11 support a wafer between them at points just below their horizontal diameter.

Drive means 13 comprises a linear motion guiding means 15 mounted on a crank member 16 which in turn is mounted in pivot 17. Guiding means 15 comprises tube member 18, a rod member 19 and a slide member 20 to which cradle connecting arm 12 is connected. Tube member 18 contains a drive motor (described below), and rod member 19 prevents slide member 20 from rotating. Slide member 20 is free to slide on members 18 and 19 in the direction of arrow 21, whilst crank member 16 pivots on pivot 17 in the direction of arrow 22. Pivot 17 is mounted from the wall of the processing chamber, and is positioned so that wafers 8 in transporting cradle 9 are aligned with the planes they will occupy in processing stations 23, 24 and 25 after they have been loaded. After the wafers 8 have been loaded into cradle 9 by the pick-up means 5, crank member 16 is turned until cradle 9 is clear of wafer carrying member 26 which has processing stations 23, 24 and 25. Slide member 20 is then raised to the top of tube member 18 and rod member 19, and the crank member 16 is then turned back to its original position. Wafers 8 will now be situated directly above the processing stations 23 -25. Stop members 27, 29, and 31 and wafer support members 28, 30, and 32, are provided at each station, adapted so that the wafers are held in planes spaced at different distances from wafer support member 26, with the wafer in station 25 being spaced farther from member 26, and the distance between the planes being equal to the spacing of the wafers in cradle 9.

It will be appreciated that in the case of the embodiment shown in figure 1, the wafer transferring locations are coincident with the positions which the wafers occupy when in the processing stations 23, 24, and 25, so that reference numerals 23, 24 and 25 also identify the transferring locations.

The wafer locating means preferably comprises two wheels 34, perpendicular to the planes of wafers 8 and mounted with their axles horizontal,on each of shoes 10 and 11, as shown in figure 1. Preferably these wheels comprise vacuum compatible ball races. More than one wheel may be provided on at least one of the shoes, disposed one above the other as explained below.

After crank member 16 has been turned back to its original position with slide member 20 at its highest point, member 20 is then lowered so that wheels 34 contact carrying member 26 and accurately align wafers 8 with the planes of processing stations 23 -25, whilst springs 33 compensate for any misalignment. In an alternative embodiment, more than one wheel may be provided on each shoe to ensure that the wafers remain exactly parallel to carrying member 26 during this phase of the loading. As member 20 is lowered, wafer holding means 27 and 28, the stop and support members respectively of processing station 23, engage the first of wafers 8 and locate it in station 23, and subsequently holding means 29 and 30 engage the second wafer and locate it in station 24. Finally, the third wafer is engaged by holding means 31 and 32 in station 25. Wafers are unloaded by reversing the sequence of operation. Cradle 9 is first positioned below stations 23 -25 and then raised with wheels 34 contacting member 26 so that wafers in stations 25, 24 and 23 are collected in turn by cradle 9. Crank member 16 is then rotated so that the cradle can be lowered, and then rotated back to the position shown in figure 1. Wafer pick-up means 5 is then raised to lift the wafers from the cradle, tilted clear of the cradle and lowered back to deposit the wafers in their positions in the cassette.

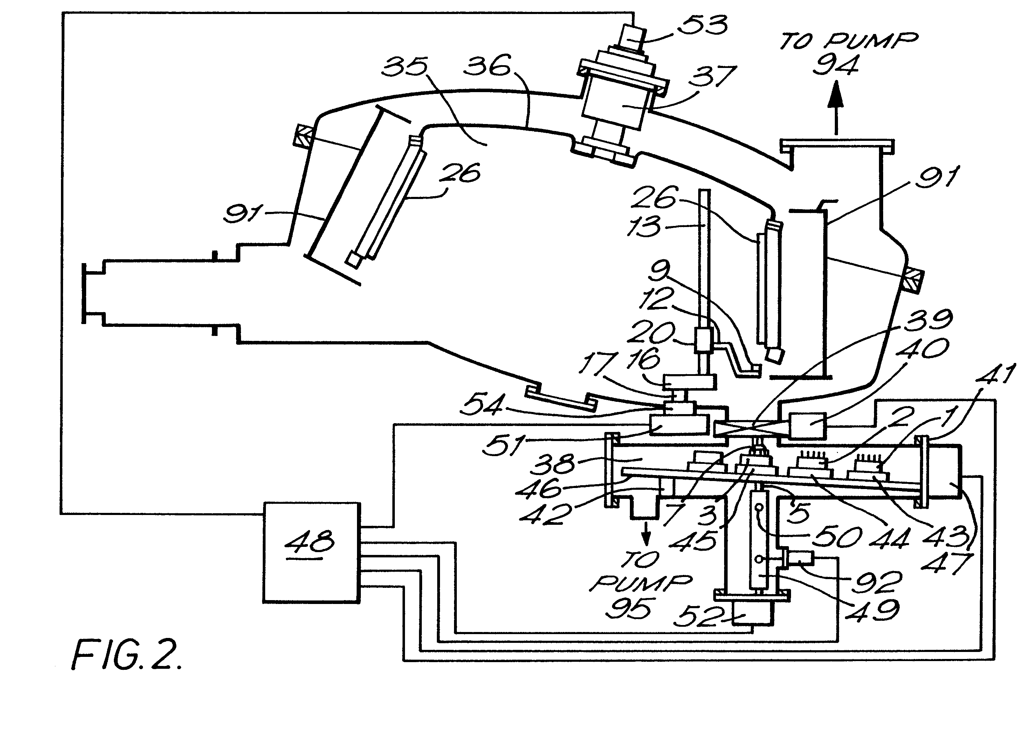

Referring next to figure 2, which shows an embodiment of the invention incorporated in an ion implanter, plasma etcher, or sputter coater, evacuated processing chamber 35 contains a rotating drum 36 on the sides of which are mounted a plurality of wafer carrying members 26. Drum 36 is supported by bearing 37 which incorporates a ferrofluidic seal and is driven by motor 53. Vacuum lock 38, evacuated by pump means 95, is connected to process chamber 35 via vacuum isolating valve 39 operated by actuator motor 40. Access to vacuum lock 38 is gained through vacuum tight entrance door 41. Storage cassettes 1, 2 and 3, supported on sliding carriages 43-45 respectively, contain the wafers to be processed. Carriages 43-45 are driven by conveyor means 46 which is attached to door 41 and supported inside lock 38 by support 42. Conveyor means 46 is upwardly inclined in lock 38 to minimize rattle of the wafers in the cassettes. Any suitable type of conveyor mechanism can be used for cassettes 1 -3 providing that it is capable of indexing them accurately over the wafer pick-up means, but preferably carriages 43 -45 are slidably mounted on two rod-like members and motion is provided by at least one magnetically coupled linear motion actuator -(described below) which is driven by actuator motor 47. This may be contained in one of the rod-like members used to guide the carriages. In this way, very few moving parts are present in the vacuum system and the generation of particulate contamination is minimized. Appropriate position sensors -(not shown), conveniently photoelectric devices, may also be used to provide feedback to the conveyor control system (part of loader controller 48) to ensure accurate positioning of the cassettes.

The wafer pick-up shoe 7, supported on wafer pick-up means 5, is driven by a second magnetically coupled linear motion actuator 49 which in turn is driven by motor 52 through a flexible coupling. The tilting motion of pick-up means 5 is conveniently provided by mounting actuator 49 on pivot 50 and connecting another point on actuator 49 to a small travel linear actuator 92, typically bellows sealed. However, many other methods of providing the tilt motion of pick-up means 5 are possible without departing from the invention. As can be seen from figure 2, pick-up means 5 is located to lift wafers through isolating valve 39 into the processing chamber to a point immediately beneath the processing stations 23-25 on one of wafer carrying members 26 mounted inside drum 36.

Drive means 13, better seen in figure 1, is mounted on pivot 17 in a bearing 54 which incorporates a ferrofluidic seal. Pivot 17 is driven by dual actuator motor 51 which also provides motive power for linear guiding means I5 (figure 1) through a shaft concentric with pivot 17. Motion may be transmitted from this shaft to the magnetically coupled actuator in tube member 18 by means of a toothed belt drive enclosed in a crank member 16, which is constructed in the form of a sealed hollow enclosure, but other methods are also suitable. Bearing 54 is positioned so that cradle 9 on the end of arm 12 can be positioned underneath the processing stations, as described.

In operation, processing chamber 35 is maintained evacuated at all times using pump means 94. In order to load the wafers, isolating valve 39 is closed by motor 40 and entrance door 41 is removed, withdrawing conveyor means 46 complete with carriages 43-45 from lock 38. Storage cassettes 1-3 are then loaded on to carriages 43-45 respectively, and conveyor means 46 and door 41 are replaced. Sufficient cassettes and carriages are provided to load all processing stations on drum 36, although only four are illustrated in figure 2 for simplicity. Lock 38 is then evacuated, after which valve 39 is opened. The first wafer carrying member 26 to be loaded is indexed into alignment with wafer pick-up means 5 by rotation of drum 36 by motor 53 and the first batch of wafers in cassette 3 are indexed over the pick-up means 5 by conveyor means 46 and motor 47. Linear actuator 49 and motor 52 then lift these wafers above cradle 9, and subsequently load them into the cradle as described , with the tilting motion of pick-up means 5 provided by bellows sealed actuator 92, as described. Robot drive means 13, driven by dual motor 51, then loads the wafers from cradle 9 into processing stations 23 -25 and returns the cradle to the starting position whilst pick-up means 5 is retracted beneath conveyor means 46 and the cassettes are indexed to align the next batch of wafers with the pick-up means. After loading, drum 36 is moved to align the next wafer carrying member with the pick-up means, and the whole cycle repeated. After all the wafers are loaded, valve 39 is closed and the processing started. Wafers are unloaded and returned to their places in the cassettes after completion of the process by aligning the last of wafer carrying members 26 to be loaded with pick-up means 5, opening valve 39, and reversing the loading sequence, after which valve 39 is again closed. The cassettes are then unloaded by removing door 41 and conveyor means 46.

Loading controller 48 is used to control the sequence of operation of the entire loading and unloading process and provides control signals for each of the motors and actuators. Preferably, controller 48 comprises a suitably programmed digital computer. Various sensors, eg limit switches and photoelectric devices, are provided to indicate the positions of the various components and ensure that they are properly positioned. A shaft position encoder is provided on the drive shaft of drum 36 to provide a signal indicative of the angular rotation of the shaft so that the position of a particular wafer carrying member 26 in relation to pick-up means 5 is known. The provision of all such sensing devices on a mechanism of this type is conventional and need not be described.

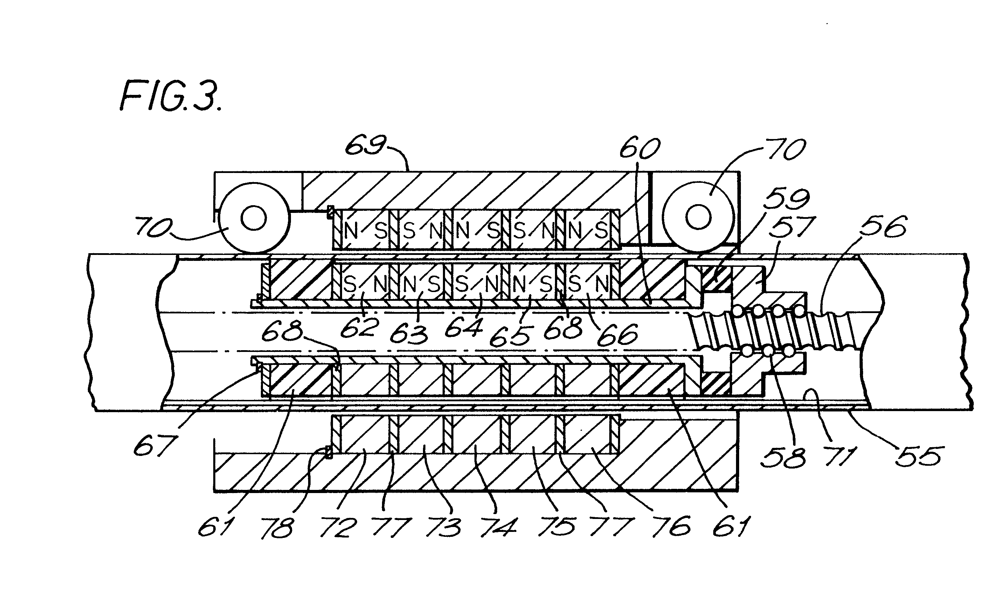

Figure 3 shows a cross section through part of a linear motion actuator suitable for use in the invention in conveyor means 46 and actuator 49. It is based on the magnetic coupling principle explained in UK patent 1,317,105, but the piston and fluid drive system of the prior patent is replaced by a leadscrew and nut drive. Non-magnetic guide tube 55, contains a leadscrew 56 supported in suitable bearings at each end of the tube (not shown). The thread of leadscrew 56 is adapted to drive nut means 57 through balls 58, comprising a conventional low friction ball and nut drive. Nut 57 is connected to magnet carriage 60 by means of flexible coupling 59, which is located inside tube 55 by means of bearing bushes 61 (typically PTFE). The flexible coupling 59, typically of rubber, prevents jamming of carriage 60 due to misalignment of tube 55 and leadscrew 56. A first magnet means comprising five ring shaped permanent magnets 62 -66 is clamped around magnet carriage 60 by washer and circlip 67. These magnets are separated by ferromagnetic spacers, typically of mild steel (some of which are shown at 68), and are orientated with the poles as shown in the figure. Guide wire 71 runs the length of tube 55 and is threaded through holes in bushes 62, preventing rotation of nut means 57 as leadscrew 56 rotates.

External carriage 69 runs on the exterior of tube 55 on vacuum compatible ball races 70. Three pairs of races are provided disposed at 120° to each other. A second magnet means comprising five ring shaped magnets 72 -76, orientated as shown and separated by ferromagnetic spacers 77, are provided inside external carriage 69 and secured by circlip 78. As magnet carriage 60 is moved inside tube 55 by leadscrew 56, carriage 69 will follow it on the exterior on tube 55, by virtue of the interaction between the two sets of magnets 62-66 and 72-76, as explained in UK patent 1,317,105.

When incorporated as part of guiding means 15, tube 55 of figure 3 becomes tube member 18 and external carriage 69 becomes sliding member 20. The upper end of the tube 18 is closed with a flat disc, and the lower end is joined in a vacuum tight manner to the upper surface of hollow crank member 16, as shown in figure 5. Leadscrew 56 carries pulley 82 and runs in a ball race 80 disposed at the lower end of tube 18. A drive shaft 83, concentric with pivot 17, runs on ball races 81 and 84 and carries pulley 85, as shown. Pulleys 82 and 85 are adapted for use with a non-slip drive such as toothed belt 86. As explained, pivot 17 is mounted in bearing 54 (figure 2) which incorporates a ferrofluidic seal. Dual actuator motor 51 provides power for rotating both pivot 17 and shaft 83, and the interior of pivot 17, crank member 16 and tube member 18 are maintained at atmosperic pressure, thereby simplifying lubrication and preventing wear particles from moving parts entering processing chamber 35.

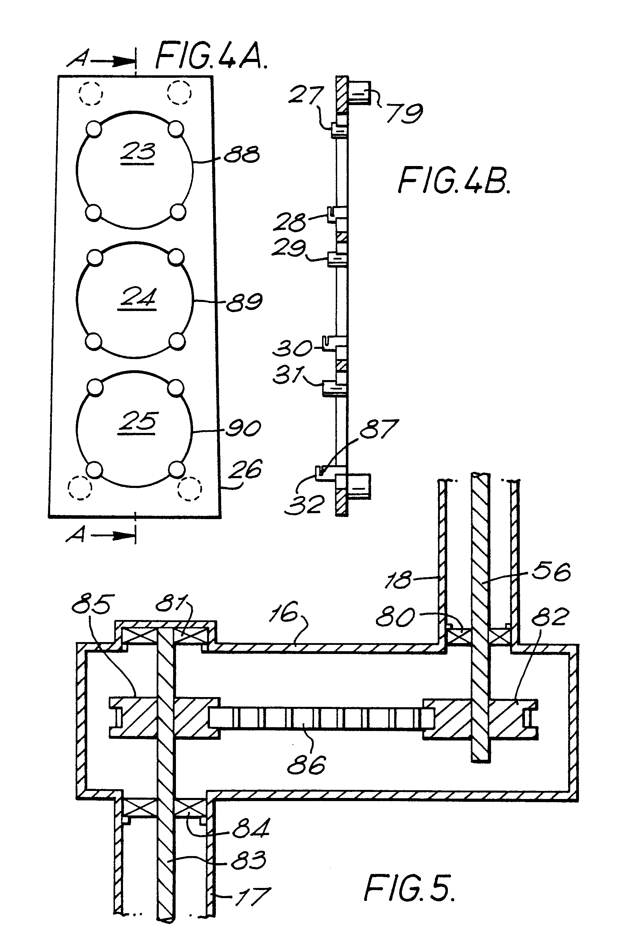

Figures 4A and 4B show two elevations of a wafer carrying member for the wafer processing apparatus. Figure 4B is a cross section viewed along the arrows A -A in figure 4A. As explained, a plurality of carrying members 26 are disposed around the circumference of drum 36 in an overlapping fashion. Mounting posts 79 are used to support the members inside drum 36. Three processing stations 23-25 are provided. Wafers are supported in slots 87 in the elongated lower support members 28, 30 and 32, which are cylindrical pillars disposed as shown. Members 28, 30 and 32 are different lengths, as shown in figure 4B, so that the wafer in station 23 is closest to carrying member 26, and that in station 25 is farthest from it. The spacing in the horizontal plane between the wafers is equal to the spacing of the grooves in shoes 10 and 11, as explained.

Upper stop members 27, 29 and 31 are also provided, disposed as shown. The length of these is selected so that each wafer is maintained parallel to member 26 when pressed against the stop member. During the processing, drum 36 is rotated and centrifugal force causes the wafers to be pressed against the stop members, so that they are maintained firmly in the desired position.

In the case of the ion implanter shown in figure 2, the wafer carrying member 26, the lower support members 28, 30 and 32 and the upper stop members 27, 29 and 31 are all made of quartz, as explained in our British patent application 8523441, filed Sept. 23, 1985 referred to above.

The large holes 88-90, at each processing station, allow efficient radiative heat transfer between the wafers and temperature controlled heat sink 91 (figure 2), permitting temperature control of the wafer during implantation.

Using apparatus of the type described, a batch of 84 125 mm diameter wafers can be automatically loaded into the implanter in less than 20 minutes, including the time required to evacuate vacuum load lock 38, which is a small fraction of a typical implant time for this number of wafers.

## Claims

1. Apparatus for transferring wafers (8) from at least one storage cassette (1,2,3) to a plurality of processing stations (23,24,25) in an evacuated chamber (35) wherein each said station is arranged to receive a single wafer and to retain it in position during processing thereof, said apparatus comprising:-

(a) a wafer pick-up means (5) capable of simultaneously removing a first plurality of wafers from said cassette;

(b) a wafer transporting cradle (9) arranged to receive said plurality of wafers from said pick-up means;

(c) drive means (13) arranged to move said cradle to each of a series of wafer transferring locations; and

(d) wafer locating means (34) operable when said cradle is at each of said transferring locations to transfer one of said plurality of wafers from said cradle to one of said processing stations.

2. Apparatus according to claim 1 further comprising a conveyor means (43-47) for said cassette (1-3), said conveyor means being operable to align successive pluralities of wafers (8) in said cassette over said pick-up means (5).

3. Apparatus according to either one of claims 1 and 2 in which said pick-up means comprises a first shoe member (7) capable of passing between the sides of said cassette (1-3) and provided with a plurality of grooves (96) arranged to receive the edge of a said wafer (8) and to support said wafer in a substantially vertical orientation, and in which said cradle comprises second and third shoe members (10,11) so spaced apart as to allow said first shoe member to pass therebetween, said second and third shoe members being arranged to support a said plurality of wafers in substantially vertical orientations at points just below their horizontal diameters, each of said second and third shoe members being provided with a plurality of grooves (96) arranged to receive the edge of a said wafer.

4. Apparatus according to claim 3 in which said pick-up means (5) is operable to lift a said plurality of wafers (8) from said cassette (1-3) by a substantially vertical upward motion, subsequently to displace said wafers in a substantially horizontal plane and subsequently to transfer said wafers into said cradle (9) by a substantially vertical downwards motion which causes said first shoe member (7) to pass between said second and third shoe members (10,11) in such a way that the grooves (96) in said first, second and third shoe members are substantially in alignment.

5. Wafer processing apparatus comprising:-

(a) a vacuum lock (38) capable of receiving at least one wafer storage cassette (1-3);

(b) a procesing chamber (35) for wafer processing, said chamber being provided with a plurality of wafer processing stations (23,24,25) each capable of receiving a single wafer (8), and a vacuum isolating valve (39) communicating with said vacuum lock;

(c) means (94,95) for separately evacuating said chamber and said lock; and

(d) wafer transferring apparatus according to any one of claims 1 to 4 arranged to transfer wafers from said cassette through said valve to said processing stations.

6. Wafer processing apparatus according to claim 5 further comprising at least one wafer carrying member (26) disposed in said chamber (35), said wafer carrying member comprising a plurality of processing stations and being provided, at each said processing station (23,24,25), with at least one stop member (27,29,31) and at least two elongated wafer support members (28,30,32), each said support member being provided with a slot arranged to receive the lower portion of a wafer (8) disposed therein substantially parallel to the plane of said carrying member, and each said stop member being arranged for contact with the upper portion of a wafer disposed in said support members whereby to prevent out-of-plane motion thereof towards said carrying member.

7. Wafer processing apparatus according to claim 6 in which each said carrying member (26) comprises three processing stations (23,24,25) and is provided at each said processing station with two said support members (28,30,32) and two said stop members (27,29,31), and in which a plurality of said carrying members are fitted to a rotatable drum (36) disposed in said chamber (35).

8. Wafer processing apparatus according to either one of claims 6 and 7 in which:

(a) at least some of said processing stations (23,24,25) of a said carrying member (26) are disposed in a substantially vertical array one above the other with stop members (27,29,31) and support members (28,30,32) so arranged that a wafer - (8) located in one said station is spaced farther from the plane of said carrying member than the wafer in the station immediately above it;

(b) said drive means (13) is arranged to position said cradle (9) above the uppermost of the processing stations in a said array and subsequently to lower it through each of said transferring locations in turn, each of said transferring locations being substantially in horizontal alignment with one processing station of said array; and

(c) said locating means comprises at least two wheels (34) disposed one on each side of said cradle (9) and spaced apart by a distance greater than the diameter of said wafers, said wheels being so disposed that when said cradle is located at the uppermost of said transferring locations with said wheels in contact with said carrying member each of the wafers in said cradle is in substantially vertical alignment with the slots in the support members associated with the processing station into which it is to be loaded.

9. Wafer processing apparatus according to any one of claims 5 to 7 having processing stations (23,24,25) substantially in vertical alignment with the locations in said cassette (1-3) occupied by a said plurality of wafers positioned for lifting from the cassette by said pick-up means (5), and in which said drive means (13) comprises a cradle connecting arm (12) linking said cradle (9) to a linear motion guiding means (15) arranged to confine the motion of said arm to a single substantially vertical axis, and a crank member (16) having a proximal end about which it is capable of pivoting and a distal end on which said linear motion guiding means is mounted, said crank member being arranged to move said guiding means clear of said processing stations to allow said cradle to be elevated on said guiding means to a point above the uppermost processing station, and subsequently to return said guiding means to permit said cradle to be lowered through each of said transferring locations in turn.

10. Wafer processing apparatus according to claim 9 in which said linear motion guiding means - (15) comprises at least one rod member (19) and at least one non-magnetic tube member (18) on both of which said cradle connecting arm (12) is slideably mounted, the interior of said tube member being sealed from said evacuated chamber - (35), and in which said drive means (13) further comprises:-

(a) a lead screw (56) disposed inside said tube member and along its axis;

(b) a nut means (57) adapted to slide within said tube member, said nut means being in threaded engagement with said lead screw, and means - (71) to prevent said nut means rotating within said tube member;

(c) a first magnet means (62-66) connected to said nut means;

(d) a second magnet means (72-76) connected to said cradle connecting arm and disposed outside said tube member in magnetic cooperation with said first magnet means whereby said cradle connecting arm may be caused to follow the movement of said nut means as said lead screw is rotated.

FIG.1.

FIG.2.

TO PUMP
94

TO
PUMP
95

0 228 901

FIG.3.

FIG.4A.

FIG.4B.

FIG.5.